(19) Europäisches Patentamt
European Patent Office
Office européen des brevets

(11) **EP 3 523 465 B1**

(12) **EUROPÄISCHE PATENTSCHRIFT**

(45) Veröffentlichungstag und Bekanntmachung des Hinweises auf die Patenterteilung:
**19.02.2020 Patentblatt 2020/08**

(21) Anmeldenummer: **17781430.8**

(22) Anmeldetag: **28.09.2017**

(51) Int Cl.:
**C30B 15/14** *(2006.01)*    **C30B 15/20** *(2006.01)*
**C30B 15/26** *(2006.01)*

(86) Internationale Anmeldenummer:
**PCT/EP2017/074603**

(87) Internationale Veröffentlichungsnummer:
**WO 2018/069051 (19.04.2018 Gazette 2018/16)**

(54) **VERFAHREN ZUM ZIEHEN EINES EINKRISTALLS AUS HALBLEITERMATERIAL AUS EINER SCHMELZE, DIE IN EINEM TIEGEL ENTHALTEN IST**

METHOD FOR PULLING A SINGLE CRYSTAL OF SEMICONDUCTOR MATERIAL FROM A MELT WHICH IS CONTAINED IN A CRUCIBLE

PROCÉDÉ POUR TIRER UN MONOCRISTAL EN MATÉRIAU SEMI-CONDUCTEUR À PARTIR D'UNE MASSE FONDUE QUI EST CONTENUE DANS UN CREUSET

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.10.2016 DE 102016219605**

(43) Veröffentlichungstag der Anmeldung:
**14.08.2019 Patentblatt 2019/33**

(73) Patentinhaber: **Siltronic AG**
**81737 München (DE)**

(72) Erfinder:
• **SCHRÖCK, Thomas**
**84556 Kastl (DE)**
• **HEUWIESER, Walter**
**84533 Stammham (DE)**

(74) Vertreter: **Staudacher, Wolfgang**
**Siltronic AG**
**Intellectual Property -LP 244**
**Johannes-Hess-Str. 24**
**84489 Burghausen (DE)**

(56) Entgegenhaltungen:
EP-A1- 0 821 082     DE-A1-102013 210 687
JP-A- H09 118 585     JP-A- 2007 045 684
US-B1- 6 203 611

EP 3 523 465 B1

**Beschreibung**

Gegenstand der Erfindung ist ein Verfahren zum Ziehen eines Einkristalls aus Halbleitermaterial aus einer Schmelze, die in einem Tiegel enthalten ist, umfassend das Ziehen des Einkristalls in einer Phase, in der ein Anfangskonus des Einkristalls entsteht, bis zu einer Phase, in der mit dem Ziehen eines zylindrischen Abschnitts des Einkristalls begonnen wird.

Stand der Technik / Probleme

Die Herstellung eines Einkristalls aus Halbleitermaterial nach der Czochralski-Methode hat üblicherweise zum Ziel, einen Einkristall zu erhalten, von dem eine möglichst große Anzahl an Halbleiterscheiben erhalten werden kann. Die Form des Einkristalls umfasst einen vergleichsweise kurzen konusförmigen Abschnitt oder Anfangskonus und einen vergleichsweise langen zylindrischen Abschnitt. Die Halbleiterscheiben werden vom zylindrischen Abschnitt erhalten. Dementsprechend umfasst das Ziehen des Einkristalls eine Phase, in der der Anfangskonus entsteht und eine Phase, in der der zylindrische Abschnitt entsteht. Das Ziehen eines Übergangs vom Anfangskonus zum zylindrischen Abschnitt wird Umbiegen (shouldering) genannt.

Die Regelung (closed loop control) des Durchmessers des Einkristalls auf einen Zieldurchmesser ist während der Phase des Umbiegens nicht empfehlenswert, weil die dafür notwendige Messung des Durchmessers des Einkristalls Störungen unterliegt. Der Durchmesser des wachsenden Einkristalls lässt sich nur anfänglich direkt messen, solange kein heller Ring am Meniskus sichtbar ist. Als Meniskus wird der sich von der Oberfläche der Schmelze bis zum unteren Rand des wachsenden Einkristalls erhebende Teil der Schmelze bezeichnet, der sich auf Grund von Oberflächenspannungs- und Grenzflächenspannungs-Effekten bildet. Im Meniskus spiegeln sich glühend heiße Bestandteile der näheren Umgebung des Einkristalls, wie beispielsweise die Tiegelwand. Die Spiegelung der Tiegelwand wird auf einer Kamera-Aufnahme vom Bereich der Phasengrenze zwischen wachsendem Einkristall und Schmelze als heller Ring wahrgenommen. Das Erscheinen des hellen Rings verlegt den Hell/Dunkel-Übergang nach außen und macht so die direkte Messung des Durchmessers des Einkristalls und eine darauf beruhende Regelung des Durchmessers unmöglich.

Die DE 10 2013 210 687 A1 offenbart ein Verfahren zur Regelung des Durchmessers eines Einkristalls auf einen Solldurchmesser während des Ziehens des Einkristalls aus einer Schmelze, die in einem Tiegel enthalten ist und einen Meniskus an einer Phasengrenze am Rand des Einkristalls bildet, wobei der Meniskus eine Höhe aufweist, die dem Abstand zwischen der Phasengrenze und einem Niveau der Oberfläche der Schmelze außerhalb des Meniskus entspricht, umfassend das wiederholte Durchführen der folgenden Schritte: das Bestimmen des Durchmessers eines hellen Rings auf dem Meniskus; das Berechnen eines Durchmessers des Einkristalls unter Berücksichtigung des Durchmessers des hellen Rings und unter Berücksichtigung der Abhängigkeit des Durchmessers des hellen Rings von der Höhe des Meniskus und vom Durchmesser des Einkristalls selbst; und das Berechnen von mindestens einer Stellgröße zur Regelung des Durchmessers des Einkristalls beruhend auf dem Unterschied zwischen dem berechneten Durchmesser des Einkristalls und dem Solldurchmesser des Einkristalls.

Die EP 0 821 082 A1 offenbart ein vollständig vorhersehendes Mehrgrößensteuersystem zur Regulierung von Einkristallwachstumsprozessen.

Die JP 2007 045684 A offenbart einen geschlossenen Regelkreis für ein Verfahren zum Ziehen eines Einkristalls, umfassend eine modellprädiktive Regelung.

In der WO 01/29292 A1 ist ein Verfahren beschrieben, umfassend das Vorhersagen eines Durchmessers, bei dessen Erreichen mit dem Umbiegen begonnen wird, und zwar in der Weise, dass beim Erreichen des vorhergesagten Durchmessers die Ziehgeschwindigkeit von einer ersten auf eine zweite Sollziehgeschwindigkeit erhöht wird.

Dieses Verfahren ist nicht besonders flexibel, weil nicht bei einem beliebigen Durchmesser, sondern nur beim vorhergesagten Durchmesser mit dem Umbiegen begonnen werden kann.

Aufgabe der vorliegenden Erfindung ist die Bereitstellung eines Verfahrens, das eine solche Einschränkung nicht hat.

Die Aufgabe der Erfindung wird gelöst durch ein Verfahren zum Ziehen eines Einkristalls aus Halbleitermaterial aus einer Schmelze, die in einem Tiegel enthalten ist, umfassend das Ziehen des Einkristalls in einer Phase, in der ein Anfangskonus des Einkristalls entsteht, bis zu einer Phase, in der mit dem Ziehen eines zylindrischen Abschnitts des Einkristalls begonnen wird, umfassend

das Messen des Durchmessers Dcr des Anfangskonus des Einkristalls und das Berechnen der Änderung des Durchmessers dDcr/dt;

das Ziehen des Anfangskonus des Einkristalls aus der Schmelze mit einer Ziehgeschwindigkeit vp(t) von einem Zeitpunkt t1 bis zu einem Zeitpunkt t2, ab dem mit dem Ziehen des zylindrischen Abschnitts des Einkristalls bei einem Zieldurchmesser Dcrs begonnen wird, wobei bei einem vorgegebenen Verlauf der Ziehgeschwindigkeit vp(t) die Differenz $\Delta t = t2 - t1$ solange mittels eines iterativen Rechenprozesses verändert wird, bis der Zeitpunkt t2 mit dem Erreichen des Zieldurchmessers Dcrs übereinstimmt. Das Verfahren ermöglicht, mit dem Umbiegen zu einem beliebigen Zeitpunkt t1 beginnen zu können und über die Steuerung der Ziehgeschwindigkeit zum Zieldurchmesser zu gelangen. Der Zieldurchmesser ist der Durchmesser, den der zylindrische Abschnitt des Einkristalls haben soll.

Gemäß einer bevorzugten Ausgestaltung der Erfindung umfasst die Zufuhr von Wärme zum wachsenden Einkristall auch die Zufuhr von Wärme zur Phasengrenze zwischen dem Rand des Einkristalls und der Schmelze durch eine ringförmige Heizvorrichtung. Die ringförmige Heizvorrichtung ist über der Schmelze angeordnet. Diese Zufuhr von Wärme erfolgt zumindest im Zeitraum vom Zeitpunkt t1 bis zum Zeitpunkt t2, vorzugsweise auch zumindest während des Ziehens des zylindrischen Abschnitts des Einkristalls. Für den Zeitraum vom Zeitpunkt t1 bis zum Zeitpunkt t2 wird der Verlauf der Heizleistung LstR(t) der ringförmigen Heizvorrichtung vorausbestimmt, auf Grund dessen die Wachstumsgeschwindigkeit des Einkristalls vcr(t2) zum Zeitpunkt t2 einen vorgesehenen Wert vcrs erreicht.

Es ist nämlich bekannt, dass die Konzentration von Punktdefekten im Einkristall und der Typ der dominierenden Art von Punktdefekten entscheidend vom Wert des Quotienten vcr/G abhängt, wobei G der axiale Temperaturgradient an der Phasengrenze zwischen dem Einkristall und der Schmelze ist. Der axiale Temperaturgradient G wird im Wesentlichen von der hot zone bestimmt, womit die nähere Umgebung des wachsenden Einkristalls gemeint ist, die Einfluss auf das Temperaturfeld im Einkristall und der Schmelze hat. Für eine bestimmte hot zone kann der axiale Temperaturgradient G durch Simulationsrechnungen näherungsweise bestimmt werden.

Die Wachstumsgeschwindigkeit des Einkristalls vcr(t2) zum Zeitpunkt t2 soll daher vorzugsweise einen Wert annehmen, durch den der Quotient vcr(t2)/G einen gewünschten Soll-Wert hat. Gemäß einer besonders bevorzugten Ausgestaltung des Verfahrens liegt der gewünschte Soll-Wert des Quotienten in einem Bereich, der zur Folge hat, dass Punktdefekte im Einkristall nur in Konzentrationen gebildet werden, die vergleichsweise gering sind und keine Agglomerate von Punkdefekten oder nur solche, deren Durchmesser nicht mehr als 5 nm beträgt, gebildet werden. Besonders bevorzugt ist darüber hinaus, den Quotienten derart einzustellen, dass entweder Leerstellen oder Zwischengitteratome als Punktdefekt-Art über den gesamten Radius des Einkristalls dominieren.

Dadurch, dass sichergestellt ist, dass der Quotient vcr(t2)/G den Soll-Wert bereits zum Zeitpunkt t2 hat, zu dem mit dem Ziehen des zylindrischen Abschnitts des Einkristalls begonnen wird, werden Ausbeuteverluste vermieden, die entstünden, wenn erst nach dem Erreichen des Zieldurchmessers des zylindrischen Abschnitts des Einkristalls der Wert des Quotienten an den Soll-Wert angepasst werden müsste. Die ringförmige Heizvorrichtung kann beispielsweise ausgeführt sein wie eine, die in US 2013/0014695 A1 beschrieben ist, und beispielsweise angeordnet sein, wie es in US 2008/0153261 A1 gezeigt ist.

Die Erfindung sieht den nachstehend beschriebenen Ablauf vor. Halbleitermaterial, vorzugsweise Silizium, wird in einem Tiegel geschmolzen. Die Spitze eines einkristallinen Keimkristalls wird in die Schmelze getaucht, und der Keimkristall von der Schmelze weggezogen, wobei am Keimkristall haftendes Material der Schmelze kristallisiert. Zunächst wird ein halsförmiger Abschnitt (neck) gezogen, um Versetzungen zu beseitigen.

Anschließend wird der Durchmesser des wachsenden Einkristalls erweitert, wodurch der Anfangskonus entsteht. Während dieser Phase bis zum Zeitpunkt t1, zu dem mit dem Umbiegen begonnen wird, wird der Einkristall vorzugsweise in einer Weise gezogen, die eine Regelung umfasst. Die Regelung kann eine Regelung auf den Durchmesser des Einkristalls sein. Bevorzugt ist der Einsatz einer Regelung auf den Kristallwinkel, also einer Regelung, bei der als Führungsgröße der Kristallwinkel vorgegeben wird, den der Anfangskonus im Bereich der Phasengrenze zur Schmelze mit der Vertikalen einschließen soll. Eine solche Regelung ist beispielsweise in WO 00/60145 A1 beschrieben.

Unabhängig von der Art der Regelung wird währenddessen der Durchmesser Dcr des Anfangskonus gemessen. Solange kein heller Ring ausgebildet wird, kann der Durchmesser direkt durch Auswerten eines Kamerabilds, das den Bereich der Phasengrenze zeigt, gemessen werden. Ist der helle Ring bereits sichtbar, wird der Durchmesser des hellen Rings gemessen und davon ausgehend der Durchmesser Dcr des Anfangskonus berechnet. Eine solche Vorgehensweise ist beispielsweise in EP0745830 A2 beschrieben. Den Zusammenhang zwischen dem Durchmesser Dcr und dem Durchmesser des hellen Rings Dbr drückt Gleichung (1) aus, wobei $\Delta br(MenH(t))$ die Breite des hellen Rings bezeichnet, die von der Meniskushöhe MenH abhängt, welche wiederum eine Funktion der Zeit t ist:

$$Dbr = Dcr + 2 * \Delta br(MenH(t)) \hspace{2cm} (1)$$

Zweckmäßigerweise wird das gemessene Durchmesser-Signal vor der weiteren Verwendung gefiltert, um Rauschen zu unterdrücken. Durch zeitliches Ableiten des Durchmessers wird die Änderung des Durchmessers des Anfangskonus dDcr/dt erhalten. Die Änderung des Durchmessers des Anfangskonus dDcr/dt bildet die Ausgangsgröße für das anschließende Ermitteln der Höhe MenH und der Änderung der Höhe dMenH/dt des Meniskus an der Phasengrenze.

Zunächst stellt Gleichung (2) eine Beziehung zum Kristallwinkel $\beta_{cr}$ her, wobei Voraussetzung für die Anwendung von Gleichung (2) ist, dass der sich ergebende Kristallwinkel $\beta_{cr}$ zumindest in der näheren Vergangenheit im Wesentlichen unverändert geblieben ist:

$$\tan^{-1}\left((dDcr/dt)/2vcr\right) = \beta_{cr} \qquad (2)$$

Diese Voraussetzung ist üblicherweise erfüllt, wenn zur Regelung des Ziehens des Anfangskonus eine Regelung auf den Kristallwinkel eingesetzt wird und ein konstanter Kristallwinkel als Führungsgröße vorgesehen ist.

Der Kristallwinkel $\beta_{cr}$ ist kleiner als der Meniskuswinkel $\beta$, wobei für Silizium als Unterschied im Allgemeinen 11° angenommen wird.

Es gibt verschiedene Ansätze, welche die Höhe des Meniskus in Beziehung zum Meniskuswinkel $\beta$ setzen, beispielsweise die in WO 01/29292 A1 erwähnte Lösung von Hurle oder die Lösung der Laplace-Young-Gleichung (A.Sababskis et al., Crystal shape 2D modeling for transient CZ silicon crystal growth, Journal of Crystal Growth 377 (2013) 9-16). Unter Nutzung einer solchen Beziehung kann eine Zuordnungstabelle (look-up table) vorgehalten werden, die dem Meniskuswinkel $\beta$ eine Höhe des Meniskus MenH zuordnet. Im Ergebnis kann mit Hilfe einer solchen Zuordnungstabelle die aktuelle Höhe des Meniskus MenH und deren zeitliche Änderung dMenH/dt ermittelt werden.

Gemäß Gleichung (3) entspricht die Ziehgeschwindigkeit vp der Wachstumsgeschwindigkeit vcr des Einkristalls, sofern sich die Höhe des Meniskus nicht ändert:

$$dMenH/dt = vp - vcr \qquad (3)$$

Ändert sich die Meniskushöhe, muss diese Änderung von der Ziehgeschwindigkeit vp abgezogen werden, um die Wachstumsgeschwindigkeit vcr zu erhalten. Unter der vorstehend erwähnten Voraussetzung, dass der Kristallwinkel $\beta_{cr}$ zumindest einige Zeit unverändert geblieben ist, hat sich in diesem Zeitraum auch die Meniskushöhe MenH nicht verändert und die aktuelle Wachstumsgeschwindigkeit vcr des Einkristalls entspricht der Ziehgeschwindigkeit vp.

Der Zustand des Anfangskonus zu einem beliebigen Zeitpunkt t1 kann dann hinsichtlich seines Durchmessers, der Meniskushöhe und der Wachstumsgeschwindigkeit so angegeben werden: der Durchmesser ist Dcr(t1), die Meniskushöhe ist MenH(t1) und die Wachstumsgeschwindigkeit ist vcr(t1).

Mit Kenntnis der Meniskushöhe MenH wird auch Kenntnis über die Größe des Unterschieds $\Delta$MenH = MenHs - MenH erlangt, wobei die Meniskushöhe MenHs diejenige Meniskushöhe bezeichnet, die zum Ziehen des zylindrischen Abschnitts des Einkristalls notwendig ist. Beim Erreichen einer Meniskushöhe MenHs = 7 mm ist der Meniskuswinkel $\beta = \beta_0 = 11°$, sofern das Halbleitermaterial Silizium ist.

Um zur Meniskushöhe MenHs zu gelangen, wird zum Zeitpunkt t1 die Ziehgeschwindigkeit erhöht. Die Wachstumsgeschwindigkeit vcr ändert sich mit der Meniskushöhe, wobei die Änderung in allgemeiner Form mit Gleichung (4) beschrieben werden kann, wobei f(MenH(t)) eine Funktion der Meniskushöhe MenH ist, die wiederum von der Zeit t abhängig ist:

$$vcr(t) = vcr(t2) - f(MenH(t)) \qquad (4)$$

Näherungsweise kann ein linearer Zusammenhang gemäß Gleichung (5) angenommen werden, mit einer Konstanten faktor, die experimentell oder mittels Simulation bestimmt werden kann:

$$vcr(t) = vcr(t2) - faktor * (MenHs - MenH(t)) \qquad (5)$$

Die Wachstumsgeschwindigkeit vcr(t2) zum Zeitpunkt t2 lässt sich aus den Anfangsbedingungen herleiten, vereinfacht beispielsweise nach Gleichung (6) oder in allgemeinerer Form gemäß Gleichung (7), wobei f eine frei wählbare Funktion ist, welche die Meniskushöhe auf eine Wachstumsgeschwindigkeit abbildet:

$$vcr(t2) = vp(t1) + faktor * (MenHs - MenH(t1)) \qquad (6)$$

$$vcr(t2) = vp(t1) + f(MenH(t2)) - f(MenH(t1)) \qquad (7)$$

Die in diesem Text betrachtete Wachstumsgeschwindigkeit vcr ist diejenige Komponente der Wachstumsgeschwindigkeit des Einkristalls, deren Richtung entgegengesetzt gerichtet ist zur Richtung der Ziehgeschwindigkeit vp. Erfindungsgemäß wird der passende Verlauf der Ziehgeschwindigkeit vp(t) im Intervall $\Delta$t = t2 - t1 durch iteratives numerisches Auswerten der Gleichungen (8) und (9) vorausbestimmt.

$$\partial MenH/\partial t = vp(t) - vcr(t) \qquad (8)$$

$$\partial Dcr/\partial t = vcr(t) * 2\tan\beta cr(t) \qquad (9)$$

Dabei wird die erlangte Kenntnis der Differenz ΔMenH verwertet: Sind zum Zeitpunkt t2 die Meniskushöhe MenHs und damit der Durchmesser Dcrs erreicht, entspricht ΔMenH der Fläche unter dem Verlauf der Ziehgeschwindigkeit vp(t) im Intervall Δt = t2 - t1 abzüglich der Fläche unter dem Verlauf der Wachstumsgeschwindigkeit vcr(t) im selben Intervall.

Zunächst wird ein geplanter Verlauf der Ziehgeschwindigkeit vorgegeben, der grundsätzlich beliebig sein kann. Beispielsweise hat der Verlauf in einem Diagramm, in dem vp(t) - vcr(t) gegen die Zeit t aufgetragen ist, im Intervall Δt die Form eines Rechtecks, eines Dreiecks oder eines Trapezes. In einem einfachen Fall ist die Form ein Rechteck. In einem Diagramm, in dem die Ziehgeschwindigkeit vp(t) gegen die Zeit t aufgetragen ist, wird die rechteckige Form dieser Fläche zu einem Parallelogramm. Für diesen Verlauf der Ziehgeschwindigkeit vp(t) entspricht die Fläche des Parallelogramms der Änderung der Meniskushöhe ΔMenH, die notwendig ist, um zur Meniskushöhe MenHs zu gelangen, vorausgesetzt, die zunächst nur angenommene Länge des Intervalls Δt ist korrekt. In der Regel wird das nicht der Fall sein. Der iterative Rechenprozess wird durchgeführt, um die korrekte Länge des Intervalls zu bestimmen. Durch Lösen von Gleichung (9) wird überprüft, ob die angenommene Länge des Intervalls Δt korrekt ist. Das ist der Fall, wenn zum Zeitpunkt t2 der Zieldurchmesser Dcrs erreicht wird. Wird der Zieldurchmesser Dcrs zum Zeitpunkt t2 nicht erreicht, wird ein längeres Intervall Δt angenommen und die Form des Verlaufs der Ziehgeschwindigkeit vp(t) entsprechend gestreckt, und der iterative Rechenprozess solange wiederholt, bis die korrekte Länge für das Intervall Δt gefunden wurde. Wird der Zieldurchmesser Dcrs zum Zeitpunkt t2 übertroffen, wird ein kürzeres Intervall Δt angenommen und die Form des Verlaufs der Ziehgeschwindigkeit vp(t) entsprechend gestaucht, und die Iteration solange wiederholt, bis die korrekte Länge für das Intervall Δt gefunden wurde. Der iterative Rechenprozess wird beendet, wenn die angenommene Länge des Intervalls Δt zum Zieldurchmesser Dcrs führt oder zu einem Durchmesser, dessen Abweichung vom Zieldurchmesser als noch akzeptabel angesehen wird. Die angenommene Länge des Intervalls Δt entspricht in diesen Fällen dann der korrekten Länge.

Der Zustand des Anfangskonus zum Zeitpunkt t2 hinsichtlich seines Durchmessers, der Meniskushöhe und der Wachstumsgeschwindigkeit kann dann so angegeben werden: der Durchmesser ist Dcrs, die Meniskushöhe ist MenHs und die Wachstumsgeschwindigkeit ist vcr(t2).

Das vorstehend beschriebene Vorgehen ermöglicht es, zu einem beliebigen Zeitpunkt t1 mit dem Umbiegen beginnen zu können und diesen Vorgang im Intervall Δt mit dem Erreichen des Zieldurchmessers Dcrs abschließen zu können, und anschließend das Ziehen des Einkristalls mit dem Ziehen des zylindrischen Abschnitts des Einkristalls fortsetzen zu können. Vorzugsweise wird zum Ziehen des zylindrischen Abschnitts des Einkristalls eine Regelung eingesetzt.

Beim Erreichen des Zieldurchmessers Dcrs zum Zeitpunkt t2 ist die Wachstumsgeschwindigkeit vcr(t2) nicht notwendigerweise identisch mit einer vorgesehenen Wachstumsgeschwindigkeit vcrs. Gemäß der bevorzugten Ausführungsform des erfindungsgemäßen Verfahrens nimmt die Wachstumsgeschwindigkeit des Einkristalls vcr(t2) zum Zeitpunkt t2 einen Wert an, durch den der Quotient vcr(t2)/G einen gewünschten Soll-Wert hat oder mit anderen Worten ausgedrückt, der Quotient zum Zeitpunkt t2 hat den Wert vcrs/G.

Um das zu erreichen, wird während des Intervalls Δt die Wachstumsgeschwindigkeit vcr(t) geplant verändert, indem durch Steuerung der Heizleistung LstR(t) einer ringförmigen Heizvorrichtung, die über der Schmelze angeordnet ist, Wärme zur Phasengrenze zwischen dem Rand des Einkristalls und der Schmelze zugeführt wird. Für den Zeitraum vom Zeitpunkt t1 bis zum Zeitpunkt t2 wird derjenige Verlauf der Heizleistung LstR(t) der ringförmigen Heizvorrichtung vorausbestimmt, der bewirkt, dass wegen des Zuführens der Wärme zur Phasengrenze die Wachstumsgeschwindigkeit des Einkristalls vcr(t2) zum Zeitpunkt t2 den vorgesehenen Wert vcrs hat. Die ringförmige Heizvorrichtung ist vorzugsweise konzentrisch zum Umfang des Anfangskonus über der Schmelze angeordnet.

Zum Auffinden des geeigneten Verlaufs der Heizleistung LstR(t) im Intervall Δt wird ein Zusammenhang mit dem Verlauf der Wachstumsgeschwindigkeit vcr(t) im Intervall Δt angenommen, der linear oder nicht linear sein kann und experimentell oder durch Simulation aufgefunden werden kann. Der Einfachheit wegen wird beispielsweise von einem linearen Zusammenhang ausgegangen, den Gleichung (10) repräsentiert.

$$\Delta vcr(t) = const * \Delta LstR(t) \qquad (10)$$

Die Konstante const kann beispielsweise experimentell oder mittels Simulation bestimmt werden. Um die Wachstumsgeschwindigkeit vcr(t1) zum Zeitpunkt t1 innerhalb des Intervalls $\Delta$t zur Wachstumsgeschwindigkeit vcrs zum Zeitpunkt t2 zu verändern, ist also eine Änderung der Heizleistung erforderlich, die proportional zur vorgesehenen Änderung der Wachstumsgeschwindigkeit $\Delta$vcr = vcrs - vcr(t1) ist und auf Grund der Kenntnis von $\Delta$vcr herbeigeführt werden kann.

Das Vorausbestimmen des Verlaufs der Ziehgeschwindigkeit vp(t) im Intervall $\Delta$t geschieht wie bereits beschrieben, mit dem Unterschied, dass der iterative Rechenprozess einen Verlauf der Wachstumsgeschwindigkeit vcr(t) im Intervall $\Delta$t zu Grunde legt, bei dem die Wachstumsgeschwindigkeit zum Zeitpunkt t2 die Wachstumsgeschwindigkeit vcrs ist. Am Ende des iterativen Rechenprozesses stehen dann für das Intervall $\Delta$t der Verlauf der Ziehgeschwindigkeit vp(t) und der Verlauf der Wachstumsgeschwindigkeit vcr(t) und wegen des vorstehend erwähnten Zusammenhangs auch der Verlauf der Heizleistung LstR(t) fest, und Ziehgeschwindigkeit vp(t) und Heizleistung LstR(t) werden entsprechend des jeweiligen Verlaufs vom Zeitpunkt t1 an gesteuert geändert.

Der Zustand des Anfangskonus zum Zeitpunkt t2 hinsichtlich seines Durchmessers, der Meniskushöhe und der Wachstumsgeschwindigkeit kann dann so angegeben werden: der Durchmesser ist Dcrs, die Meniskushöhe ist MenHs und die Wachstumsgeschwindigkeit ist vcrs.

Das Vorausbestimmen des Verlaufs der Ziehgeschwindigkeit vp(t) im Intervall $\Delta$t oder das Vorausbestimmen des Verlaufs der Ziehgeschwindigkeit vp(t) im Intervall $\Delta$t und des Verlaufs der Heizleistung LstR(t) im Intervall $\Delta$t geschieht vorzugsweise in einer SPS-Einheit (speicherprogrammierbare Steuerung) der Ziehanlage, wodurch sichergestellt ist, dass der iterative Rechenprozess ausreichend schnell abläuft und zum Zeitpunkt t1 oder vernachlässigbar später beendet ist.

Die Erfindung wird nachfolgend unter Bezugnahme auf Zeichnungen weiter erläutert.

### Kurzbeschreibung der Figuren

Fig. 1 zeigt schematisch die Umgebung der Phasengrenze zwischen dem Rand des wachsenden Einkristalls und der Schmelze.

Fig.2 ist ein Diagramm, in dem die Differenz (vp-vcr) gegen die Zeit t aufgetragen ist.

Fig.3 ist ein Diagramm, in dem die Differenz $\Delta$vcr gegen die Meniskushöhe MenH aufgetragen ist.

Fig.4 ist ein Diagramm, in dem der Durchmesser Dcr des wachsenden Einkristalls gegen die Zeit t aufgetragen ist.

Fig.5 und Fig.6 sind Diagramme, in denen die Ziehgeschwindigkeit vp beziehungsweise die Wachstumsgeschwindigkeit vcr gegen die Zeit t aufgetragen sind.

### Liste der verwendeten Bezugszeichen

| | |
|---|---|
| TRP | Phasengrenze zwischen dem Rand des Einkristalls und der Schmelze |
| ML | Oberfläche der Schmelze |
| MenH | Meniskushöhe |
| MenHs | Meniskushöhe beim Wachsen des zylindrischen Abschnitts |
| s | feste Phase, Anfangskonus |
| l | flüssige Phase |
| g | gasförmige Phase |
| $\beta_0$ | Unterschied zwischen $\beta$ und $\beta$cr |
| $\beta$ | Meniskuswinkel beim Wachsen des Anfangskonus |
| $\beta$cr | Kristallwinkel |
| vp | Ziehgeschwindigkeit |
| vcr | Wachstumsgeschwindigkeit |
| vcrs | vorgesehene Wachstumsgeschwindigkeit |

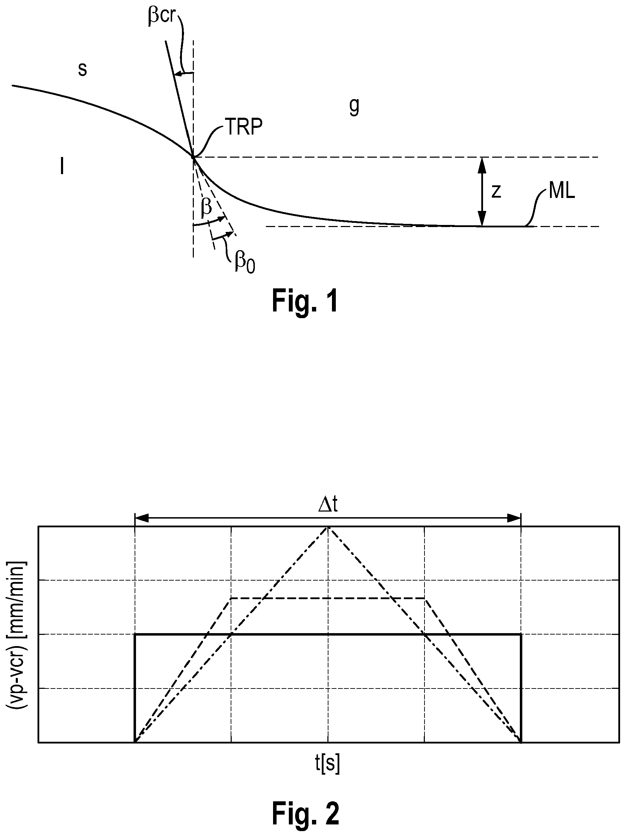

Fig.1 zeigt schematisch die Umgebung der Phasengrenze zwischen dem Rand des wachsenden Einkristalls und der Schmelze. Dargestellt ist die Phasengrenze TRP (Tripelpunkt) zwischen fester, flüssiger und gasförmiger Phase (s, I, g), wobei die feste Phase s vom Anfangskonus und die flüssige Phase I von der Schmelze gebildet werden. Zum Rand des Einkristalls hin ist die Schmelze zu einem Meniskus erhöht, der sich über die Meniskushöhe MenH von der Oberfläche ML der Schmelze erhebt.

Fig.2 zeigt ein Diagramm, in dem die Differenz (vp - vcr) von Ziehgeschwindigkeit vp und Wachstumsgeschwindigkeit vcr gegen die Zeit t in einem Zeitintervall Δt aufgetragen ist. Zu sehen ist an drei Beispielen, wie der geplante Verlauf von vp im Intervall Δt gewählt sein kann, nämlich so, dass der Verlauf in der Darstellung rechteckig, dreieckig beziehungsweise trapezförmig ist.

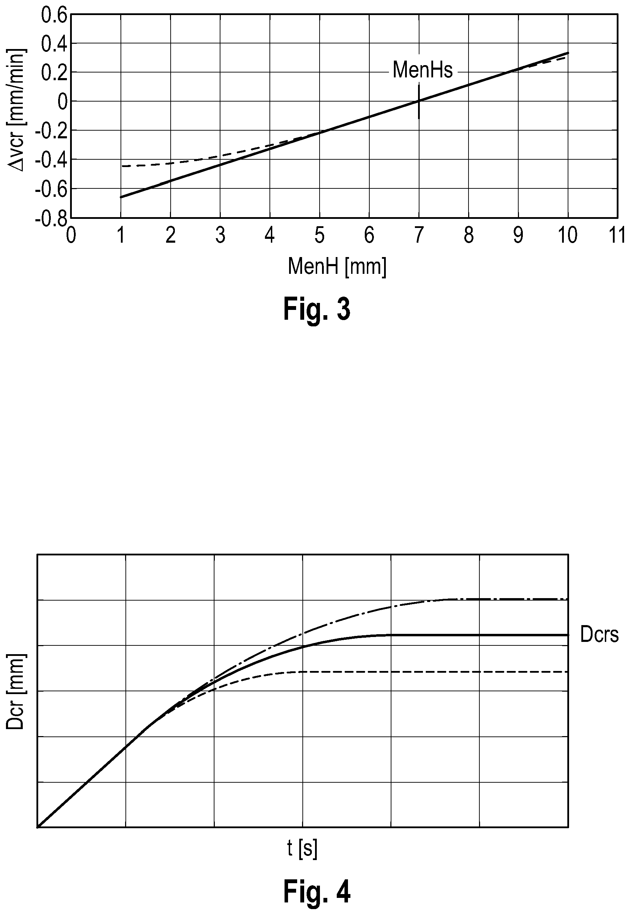

Fig.3 ist ein Diagramm, in dem die Differenz Δvcr gegen die Meniskushöhe MenH aufgetragen ist. Die durchgezogene Linie beschreibt einen linearen Zusammenhang, der näherungsweise angenommen werden kann, die gestrichelte Kurve einen nichtlinearen Zusammenhang, der besonders dann als Alternative in Betracht kommt, wenn die Differenz Δvcr vergleichsweise groß ist.

Fig.4 ist ein Diagramm, in dem der Durchmesser Dcr des wachsenden Einkristalls gegen die Zeit t aufgetragen ist. Im iterativen Rechenprozess wird überprüft, ob beim angenommenen Verlauf der Ziehgeschwindigkeit vp und der Wachstumsgeschwindigkeit vcr im angenommenen Intervall Δt am Ende des Intervalls der Durchmesser des Einkristalls den Zieldurchmesser Dcrs erreicht. Typischerweise ergibt die Überprüfung zunächst einen Enddurchmesser entsprechend der gestrichelten Kurven, der größer oder kleiner als der Zieldurchmesser Dcr ist. Unter Beibehaltung der Form des angenommenen Verlaufs von Ziehgeschwindigkeit vp und Wachstumsgeschwindigkeit vcr wird die Länge des Intervalls entsprechend verändert und der iterative Rechenprozess solange fortgesetzt, bis die Überprüfung eine Durchmesserentwicklung entsprechend der durchgezogenen Kurve ergibt, durch die am Ende des Intervalls Δt der Zieldurchmesser Dcrs erreicht wird.

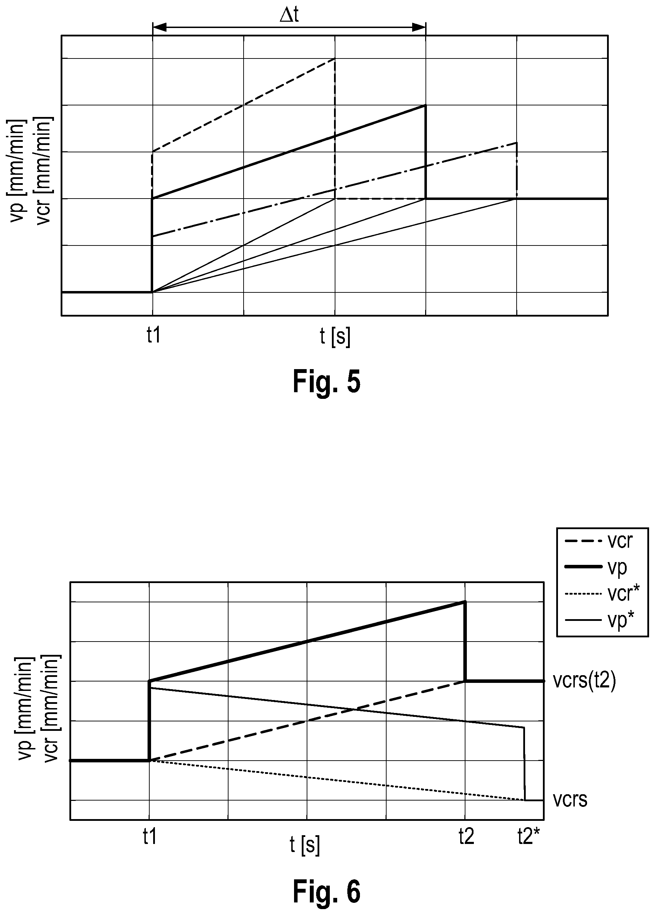

Fig.5 ist ein Diagramm, in dem die Ziehgeschwindigkeit vp beziehungsweise die Wachstumsgeschwindigkeit vcr gegen die Zeit aufgetragen ist. Es sind jeweils drei verschiedene Verlaufspaare dargestellt, zwei mit einem durch gestrichelte Linien symbolisierten Verlauf der Ziehgeschwindigkeit vp und ein Verlaufspaar, bei dem eine durchgezogene Linie den Verlauf der Ziehgeschwindigkeit vp symbolisiert. Die Flächen zwischen den jeweiligen Verlaufspaaren sind gleich groß und repräsentieren denselben Unterschied ΔMenH bezüglich der Meniskushöhe, der überwunden werden muss, um vom Zeitpunkt t1 an zur Meniskushöhe MenHs zu gelangen, die zum Ziehen des zylindrischen Abschnitts des Einkristalls notwendig ist. Ausgehend von einem Verlaufspaar mit gestrichelten Verläufen der Ziehgeschwindigkeit vp führt der iterative Rechenprozess zu dem Ergebnis, dass der Zieldurchmesser Dcr erreicht wird, wenn dasjenige Verlaufspaar realisiert wird, bei dem die durchgezogene Linie den Verlauf der Ziehgeschwindigkeit vp symbolisiert. Nur im Falle dieses Verlaufspaares hat das Intervall Δt die korrekte Länge.

Fig.6 ist ein Diagramm, in dem die Ziehgeschwindigkeit vp beziehungsweise die Wachstumsgeschwindigkeit vcr gegen die Zeit aufgetragen ist. Dargestellt ist ein typischer Verlauf der Ziehgeschwindigkeit vp und der Wachstumsgeschwindigkeit vcr in einem Intervall Δt = t2 - t1 beziehungsweise ein typischer Verlauf der Ziehgeschwindigkeit vp* und der Wachstumsgeschwindigkeit vcr* in einem Intervall Δt = t2* - t1, die dazu führen, dass am Ende des Intervalls der Durchmesser des Einkristalls den Zieldurchmesser Dcrs erreicht. Der Verlauf von vp, vcr und Δt = t2 - t1 sind das Ergebnis des iterativen Rechenprozesses, der eine geplante Veränderung der Wachstumsgeschwindigkeit durch Steuerung der Heizleistung LstR(t) einer ringförmigen Heizvorrichtung hin zu einer vorgesehenen Wachstumsgeschwindigkeit vcrs nicht vorsieht. Der Verlauf von vp*, vcr* und Δt = t2* - t1 sind das Ergebnis des iterativen Rechenprozesses, der eine geplante Veränderung der Wachstumsgeschwindigkeit durch Steuerung der Heizleistung LstR(t) einer ringförmigen Heizvorrichtung hin zu einer vorgesehenen Wachstumsgeschwindigkeit vcrs vorsieht.

**Patentansprüche**

1. Verfahren zum Ziehen eines Einkristalls aus Halbleitermaterial aus einer Schmelze, die in einem Tiegel enthalten ist, umfassend
das Ziehen des Einkristalls in einer Phase, in der ein Anfangskonus des Einkristalls entsteht, bis zu einer Phase, in der mit dem Ziehen eines zylindrischen Abschnitts des Einkristalls begonnen wird, umfassend
das Messen des Durchmessers Dcr des Anfangskonus des Einkristalls und das Berechnen der Änderung des Durchmessers dDcr/dt;
das Ziehen des Anfangskonus des Einkristalls aus der Schmelze mit einer Ziehgeschwindigkeit vp(t) von einem Zeitpunkt t1 bis zu einem Zeitpunkt t2, ab dem mit dem Ziehen des zylindrischen Abschnitts des Einkristalls bei einem Zieldurchmesser Dcrs begonnen wird, wobei bei einem vorgegebenen Verlauf der Ziehgeschwindigkeit vp(t) die Differenz
Δt = t2 - t1 solange mittels eines iterativen Rechenprozesses verändert wird, bis der Zeitpunkt t2 mit dem Erreichen des Zieldurchmessers Dcrs übereinstimmt.

2. Verfahren nach Anspruch 1, umfassend

das Zuführen von Wärme zur Phasengrenze zwischen dem Rand des Einkristalls und der Schmelze durch Steuerung der Heizleistung LstR(t) einer ringförmigen Heizvorrichtung, die über der Schmelze angeordnet ist, und

das Vorausbestimmen des Verlaufs der Heizleistung LstR(t) der ringförmigen Heizvorrichtung vom Zeitpunkt t1 bis zum Zeitpunkt t2 mittels des iterativen Rechenprozesses, so dass die Wachstumsgeschwindigkeit des Einkristalls zum Zeitpunkt t2 eine vorgesehene Wachstumsgeschwindigkeit vcrs ist.

## Claims

1. a method of pulling a single crystal of semiconductor material from a melt contained in a crucible, comprising pulling the single crystal in a phase in which an initial cone of the single crystal is formed until a phase in which pulling of a cylindrical portion of the single crystal is started, comprising

   measuring the diameter Dcr of the initial cone of the single crystal and calculating the change in diameter dDcr/dt;
   pulling the initial cone of the single crystal from the melt at a pulling speed vp(t) from a time t1 to a time t2 from which pulling of the cylindrical portion of the single crystal at a target diameter Dcrs is started, wherein at a predetermined course of the pulling speed vp(t) the difference $\Delta t = t2 - t1$ is changed by means of an iterative calculation process until the time t2 coincides with the target diameter Dcrs being reached.

2. a process according to claim 1 comprising

   supplying heat to the phase boundary between the edge of the single crystal and the melt by controlling the heating power LstR(t) of an annular heater disposed above the melt, and predetermining the course of the heating power LstR(t) of the annular heating device from time t1 to time t2 by means of the iterative calculation process, so that the growth rate of the single crystal at time t2 is an intended growth rate vcrs.

## Revendications

1. procédé de tirage d'un monocristal de matériau semiconducteur à partir d'une masse fondue contenue dans un creuset, comprenant les étapes consistant à

   le tirage du monocristal dans une phase dans laquelle un cône initial du monocristal est formé jusqu'à une phase dans laquelle le tirage d'une partie cylindrique du monocristal est amorcé, comprenant

   mesure du diamètre Dcr du cône initial du monocristal et calcul de la variation du diamètre dDcr/dt ;
   tirer le cône initial du monocristal de la masse fondue à une vitesse de tirage vp(t) d'un temps t1 à un temps t2 à partir duquel on commence à tirer la partie cylindrique du monocristal à un diamètre cible Dcrs, la différence vp(t), à une vitesse de tirage prédéterminée, étant la suivante $\Delta t = t2 - t1$ est modifié au moyen d'un processus de calcul itératif jusqu'à ce que le temps t2 coïncide avec l'atteinte du diamètre cible Dcrs.

2. un procédé selon la revendication 1 comprenant

   fournir de la chaleur à la limite de phase entre le bord du monocristal et la masse fondue en contrôlant la puissance de chauffage LstR(t) d'un élément chauffant annulaire disposé au-dessus de la masse fondue, et
   la détermination de l'évolution de la puissance de chauffage LstR(t) du dispositif de chauffage annulaire du temps t1 au temps t2 au moyen du processus de calcul itératif, de sorte que la vitesse de croissance du monocristal au temps t2 est une vitesse de croissance prévue vcrs.

**Fig. 1**

**Fig. 2**

Fig. 3

Fig. 4

Δt

vp [mm/min]
vcr [mm/min]

t1          t [s]

## Fig. 5

vcr
vp
vcr*
vp*

vp [mm/min]
vcr [mm/min]

vcrs(t2)

vcrs

t1          t [s]          t2    t2*

## Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102013210687 A1
- EP 0821082 A1
- JP 2007045684 A
- WO 0129292 A1
- US 20130014695 A1
- US 20080153261 A1
- WO 0060145 A1
- EP 0745830 A2

**In der Beschreibung aufgeführte Nicht-Patentliteratur**

- **A.SABABSKIS et al.** Crystal shape 2D modeling for transient CZ silicon crystal growth. *Journal of Crystal Growth,* 2013, vol. 377, 9-16